(19) Europäisches Patentamt
European Patent Office
Office européen des brevets

(11) **EP 2 812 711 B1**

(12) **FASCICULE DE BREVET EUROPEEN**

(45) Date de publication et mention de la délivrance du brevet:
**11.05.2016 Bulletin 2016/19**

(21) Numéro de dépôt: **13705217.1**

(22) Date de dépôt: **18.01.2013**

(51) Int Cl.:
*G01R 27/20* (2006.01)  *G01R 31/00* (2006.01)
*G01R 31/02* (2006.01)  *B60L 3/00* (2006.01)
*B60L 11/18* (2006.01)  *H02J 7/00* (2006.01)
*H02J 7/02* (2006.01)

(86) Numéro de dépôt international:
**PCT/FR2013/050116**

(87) Numéro de publication internationale:
**WO 2013/117836 (15.08.2013 Gazette 2013/33)**

(54) **SYSTÈME EMBARQUÉ SÉCURISÉ DE CHARGE DE LA BATTERIE D'UN VÉHICULE AUTOMOBILE À PARTIR D'UN RÉSEAU D'ALIMENTATION**

SICHERES BORDSYSTEM ZUM LADEN DER BATTERIE EINES KRAFTFAHRZEUGS AUS EINEM STROMNETZ

SECURE ON-BOARD SYSTEM FOR CHARGING THE BATTERY OF A MOTOR VEHICLE FROM A POWER SUPPLY NETWORK

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.02.2012 FR 1251168**

(43) Date de publication de la demande:
**17.12.2014 Bulletin 2014/51**

(73) Titulaire: **Renault S.A.S.**
**92100 Boulogne-Billancourt (FR)**

(72) Inventeurs:
• **MERIENNE, Ludovic**
  **F-91140 Villejust (FR)**
• **KETFI-CHERIF, Ahmed**
  **F-78990 Elancourt (FR)**
• **RIPOLL, Christophe**
  **F-78460 Chevreuse (FR)**
• **KONATE, Christophe**
  **F-91300 Massy (FR)**

(56) Documents cités:
EP-A1- 0 518 785      EP-A1- 1 482 317
EP-A1- 1 890 369      WO-A1-99/19963
WO-A1-2010/069739     DE-A1- 4 329 382
FR-A1- 2 382 786      US-A1- 2011 085 272

• RIFAAT R ED - NEITZEL D K: "Considerations and improvements of configuration and protection of a 72 kV mining resistance neutral grounded system", INDUSTRIAL AND COMMERCIAL POWER SYSTEMS TECHNICAL CONFERENCE, 2008. ICPS 2008. IEEE/IAS, IEEE, PISCATAWAY, NJ, USA, 4 mai 2008 (2008-05-04), pages 1-5, XP031311968, ISBN: 978-1-4244-2093-3

**Description**

L'invention concerne la sécurité d'un utilisateur d'un dispositif embarqué de charge d'une batterie d'un véhicule automobile, et plus particulièrement l'estimation de la qualité de la terre du réseau d'alimentation couplé au dispositif de charge de la batterie du véhicule automobile.

Lors de la charge d'une batterie d'un véhicule automobile électrique, des courants intenses transitent du réseau d'alimentation vers la batterie du véhicule. Pour pouvoir charger correctement le véhicule, ces courants sont hachés de manière à respecter les contraintes du réseau d'alimentation.

Le hachage des courants électriques entraîne l'apparition de courants de fuite qui doivent être évacués par la prise de terre du réseau d'alimentation. Cette prise de terre est reliée au châssis du véhicule et offre donc un chemin à tous les courants parasites.

Pour assurer une charge en toute sécurité, il faut s'assurer que la liaison à la terre soit de bonne qualité, c'est-à-dire que la résistance équivalente du chemin de terre soit faible devant la résistance qu'offrirait un être humain touchant le châssis du véhicule automobile. Sans cette liaison à la terre, un phénomène de courant de toucher peut apparaître. Si un homme venait à toucher le châssis du véhicule, c'est son corps qui établirait la liaison entre le chargeur et la terre et c'est donc par lui que passeraient tous les courants de fuites qui seraient potentiellement dangereux, sans aucun dispositif de contrôle ajouté.

Une terre de mauvaise qualité, c'est-à-dire de résistance équivalente à celle d'un corps humain, permet également le passage d'une partie des courants de fuite par le corps de l'individu. En effet, si un individu venait à toucher le châssis du véhicule en charge, dans ce cas, les courants de fuite auraient deux chemins parallèles de même résistance, donc la moitié des courants de fuite pourraient passer par l'individu pour revenir à la terre.

Pour assurer qu'aucun courant de toucher ne puisse apparaître, il faut s'assurer que la valeur de la résistance de liaison à la terre est inférieure à un certain seuil avant de charger la batterie du véhicule automobile.

Pour pouvoir estimer la résistance entre la terre et le neutre du réseau d'alimentation, il est possible d'injecter des impulsions de courant directement dans le chemin de terre et rebouclant par le neutre du réseau et de mesurer la tension entre le neutre et la terre.

Dans le cas idéal, le courant injecté dans la terre est mesuré ainsi que la tension qui est l'image du courant injecté d'après la loi d'Ohm. La valeur de la résistance est alors obtenue en divisant la tension mesurée par le courant mesuré.

Malheureusement, il est impossible d'avoir des résultats corrects aussi simplement car la tension entre le neutre et la terre est très perturbée. En effet, comme cela a déjà été mentionné plus haut, tout appareil électrique génère plus ou moins de courant de fuite. Ces courants passant par la terre également, ils viennent perturber la mesure de la tension entre le neutre et la terre.

Par exemple, dans le cas d'une résidence où les places de parking sont munies de prises de charge, il faudrait estimer la résistance dans un environnement extrêmement perturbé par tous les chargeurs de batterie en fonctionnement sur les places voisines. A ces courants de perturbations viennent s'ajouter des défauts liés au réseau d'alimentation qui provoquent une variation temporelle de la tension entre le neutre et la terre.

Certaines données sont connues sur l'ensemble de ces perturbations. En basse fréquence, notamment pour des fréquences inférieure à 1 kHz, ces perturbations sont générées aux harmoniques du réseau d'alimentation, soit par exemple 50 Hz, 100 Hz, etc., et possèdent une amplitude maximale de 7 V pour la tension efficace et de 6,6 mA pour les courants. Ces niveaux de perturbation sont définis par les normes EDF. Pour les fréquences supérieures, les normes EDF prévoient des amplitudes de courants de perturbation variant de manière continue entre 6,6 mA à 1,5 kHz et 66 mA à 15 kHz, l'amplitude du courant restant à 66 mA jusqu'à 150 kHz.

Enfin, une dernière contrainte émane du fait qu'on ne peut pas envoyer n'importe quel courant dans la terre. Il ne faut surtout pas faire disjoncter le réseau sur lequel le circuit est branché. Il est donc impossible d'envoyer des impulsions d'amplitude trop importante et/ou de durée trop longue.

L'enjeu est donc de réussir à estimer la résistance de terre malgré toutes les sources d'erreur, en respectant les contraintes imposées par l'obligation de devoir embarquer le système sur un véhicule automobile dont les processeurs fonctionnent à une fréquence maximale de 10 kHz.

Il existe dans le commerce des appareils effectuant une estimation de la résistance de la terre. Ces appareils possèdent une puissance de calcul bien supérieure à celle disponible sur un véhicule automobile et ont un prix trop élevé pour envisager d'en mettre sur chaque véhicule automobile.

Cependant, ces appareils ne sont pas configurés dans un but de gérer la sécurité d'un individu. En effet, ils ne sont configurés que pour donner l'information sur la valeur de la résistance de terre.

La demande de brevet CN 201 508 392 décrit une méthode de mesure de la résistance de la terre permettant d'éliminer une unique fréquence dans la tension neutre-terre. Cependant, les perturbations engendrées par les autres harmoniques ne sont pas éliminées et perturbent encore la mesure de la tension terre-neutre et par conséquent la détermination de la résistance de la terre.

La demande de brevet EP 1 482 317 décrit une méthode d'injection de courant de très grande amplitude de manière à améliorer le rapport signal sur bruit de la mesure de tension terre-neutre. Cependant, la méthode nécessite un environnement adapté pouvant supporter les forts pics de courants dans la terre et n'est ainsi applicable qu'en usine où les disjoncteurs tolère des fuites dix à mille fois plus importantes que les disjoncteurs d'un réseau domestique qui se déclenche généralement pour un courant supérieur à 33 mA.

La demande de brevet EP 642 027 décrit une méthode s'appuyant sur une injection de tension entre la terre et le neutre. Cependant, la mise en oeuvre d'une telle méthode requiert un système de taille bien trop importante pour être intégré au véhicule, et pour pouvoir imposer une tension au réseau.

L'invention se propose de pallier ces inconvénients à l'aide d'un système embarqué sur un véhicule automobile utilisant un procédé d'estimation de la résistance de la terre embarquée permettant de filtrer les perturbations dues au réseau d'alimentation.

Selon un aspect de l'invention, il est proposé selon un mode de réalisation, un système sécurisé de charge de la batterie d'un véhicule automobile à partir d'un réseau d'alimentation. Le système est embarqué sur le véhicule automobile et comprend des moyens de mesure de la fréquence du réseau d'alimentation, des moyens d'injection d'impulsions de courant dans le réseau d'alimentation, des moyens de mesure de la tension entre la terre et le neutre du réseau d'alimentation, un filtre analogique pour filtrer à hautes fréquences les tensions mesurées, un filtre numérique pour filtrer à basses fréquences les tensions filtrées analogiquement, et des moyens de détermination de la résistance entre la terre et le neutre du réseau d'alimentation à partir des tensions filtrées numériquement et de l'amplitude des impulsions de courant.

Selon une caractéristique générale de l'invention, le filtre numérique comprend un filtre de moyenne déterminant une moyenne à partir de N mesures de tension espacées d'un intervalle de temps $T + \dfrac{T}{N}$, avec T la période du réseau d'alimentation déterminée par les moyens de mesure de la fréquence du réseau d'alimentation.

Ainsi, pour un réseau d'alimentation classique à 50 Hz et une moyenne effectuée à partir de 40 mesures, le filtre de moyenne déterminera une moyenne à partir de 40 mesures de tension réalisées avec un intervalle entre de 20,5 ms entre deux mesures.

Les hautes fréquences comprennent les fréquences supérieures à 2 kHz et notamment celles supérieures à 5 kHz. Les basse fréquences comprennent les fréquences inférieures à 5 kHz et notamment les fréquences comprises entre 50 Hz et 2 kHz.

Dans le cas d'un réseau d'alimentation ayant une fréquence de 60 Hz et d'une moyenne réalisée à partir de 40 mesures de tension, les mesures seront espacées d'un intervalle de temps de 17,1 ms en arrondissant à 0,1 ms près (T=16,7 ms).

De préférence, le filtre analogique est un filtre analogique du second ordre avec une fréquence de coupure comprise entre 800 Hz et 1,2 kHz, et préférentiellement de 1 kHz, et un facteur d'amortissement compris entre 0,6 et 0,8, et préférentiellement de 0,7, de manière à obtenir une atténuation de -20 dB à une fréquence de 3 kHz.

Le choix d'un filtre analogique ayant de telles caractéristiques permet de diminuer au maximum la durée des impulsions de courant injectées dans le réseau d'alimentation pour effectuer les mesures. La diminution de la durée des impulsions de courant permet d'augmenter l'amplitude des impulsions de courant et ainsi d'améliorer le rapport signal/bruit.

Avantageusement, compte-tenu de la bande passante du filtre analogique, pour que la tension mesurée soit bien l'image du courant des impulsions injectées, c'est-à-dire pour tenir compte du temps de réponse du filtre analogique, les impulsions de courant ont une durée au moins supérieure à 0,8 ms, et préférentiellement de 1 ms et une amplitude maximale comprise entre 18 mA et 22 mA, et préférentiellement de 20 mA.

Le système embarqué sécurisé peut avantageusement comprendre des moyens de commande de sécurité aptes à activer la charge de la batterie à partir du réseau d'alimentation seulement si la résistance de terre mesurée est inférieure à un seuil d'activation.

Ainsi si la terre du réseau d'alimentation présente une résistance supérieure au seuil d'activation, c'est-à-dire une résistance considérée comme au moins équivalente à la résistance d'un corps humain, le réseau d'alimentation n'est pas couplé à la batterie du véhicule et la charge n'est pas débutée. Ceci afin d'éviter un risque d'apparition d'un courant de toucher.

Pour cela, le seuil d'activation peut avantageusement correspondre à une valeur de résistance comprise entre 20 et 600 Ohms, et de préférence de 200 Ohms.

Selon un autre aspect, il est proposé dans un mode de mise en oeuvre, un procédé de charge sécurisée de la batterie d'un véhicule automobile à partir d'un réseau d'alimentation estimant la résistance entre la terre et le neutre du réseau d'alimentation, dans lequel on mesure la fréquence du réseau d'alimentation, on injecte des impulsions de courant dans le réseau d'alimentation, on réalise des mesures de tension entre la terre et le neutre du réseau d'alimentation en réponse à chaque impulsion, on filtre analogiquement à hautes fréquences les tensions mesurées, on filtre numériquement à basses fréquences les tensions filtrées analogiquement, et on détermine la résistance entre la terre et le neutre à partir des tensions filtrées numériquement et de l'amplitude des impulsions de courant.

Selon une caractéristique générale, le filtrage numérique comprend la détermination d'une moyenne à partir de N mesures de tension espacées d'un intervalle de temps $T + \dfrac{T}{N}$, avec T la période du réseau d'alimentation déterminée à partir de la mesure de la fréquence du réseau d'alimentation.

De préférence, le filtrage analogique comprend un filtrage au second ordre avec une fréquence de coupure comprise entre 800 Hz et 1,2 kHz, et préférentiellement de 1 kHz, et un facteur d'amortissement compris entre 0,6 et 0,8, et préférentiellement de 0,7.

Préférentiellement, les impulsions de courant ont une durée au moins supérieure à 0,8 ms, et préférentiellement de 1 ms et une amplitude maximale comprise entre 18 mA et 22 mA, et préférentiellement de 20 mA.

De préférence, la durée des impulsions de courant injectées dans le réseau d'alimentation correspond au moins à la période du réseau d'alimentation.

Avantageusement, on peut réaliser N=40 mesures de tension entre la terre et le neutre pour éliminer les 39 premières harmoniques du réseau d'alimentation.

De préférence, on couple le réseau d'alimentation à la batterie seulement si la résistance de terre mesurée est inférieure à un seuil d'activation.

D'autres avantages et caractéristiques de l'invention apparaîtront à l'examen de la description détaillée d'un mode de réalisation et d'un mode de mise en oeuvre, nullement limitatifs, et des dessins annexés, sur lesquels :

- la figure 1 présente de manière schématique un système embarqué sécurisé de charge d'une batterie d'un véhicule automobile selon un mode de réalisation ;
- la figure 2 présente un organigramme d'un procédé d'estimation de la résistance de terre d'un réseau d'alimentation selon un mode de mise en oeuvre ;
- la figure 3 représente deux diagrammes de Bode en amplitude et en phase illustrant les actions des deux filtres du système de la figure 1.

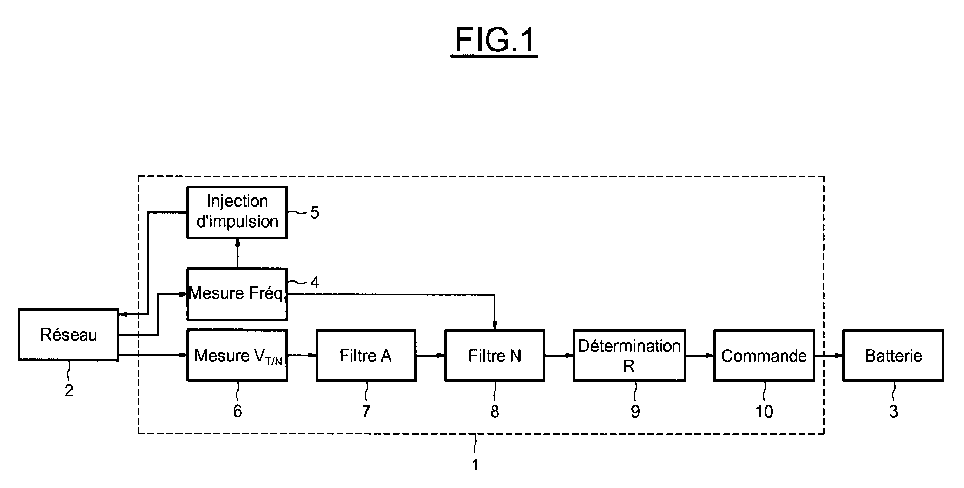

Sur la figure 1 est représenté un système sécurisé 1 selon un mode de réalisation de l'invention. Le système sécurisé 1 est embarqué à un bord d'un véhicule automobile et est destiné à être couplé entre un réseau d'alimentation 2 et une batterie 3 du véhicule automobile lors de la charge de la batterie.

Le système 1 comprend des moyens 4 de mesure de la fréquence du réseau d'alimentation 2 ainsi que des moyens 5 d'injection d'impulsions de courant dans le réseau d'alimentation 2. Les moyens 4 de mesure de fréquence sont couplés aux moyens 5 d'injection d'impulsions de courant de manière à délivrer aux moyens 5 d'injection d'impulsions de courant la valeur de la fréquence du réseau d'alimentation 2. Les moyens 5 d'injection d'impulsions de courant ajustent la durée minimum des impulsions à la période T du signal du réseau d'alimentation 2. Dans le cas d'un réseau d'alimentation 2 à 50 Hz la durée minimale des impulsions de courant sera de 1 ms.

Le système 1 comprend également des moyens de mesure 6 de la tension entre la terre et le neutre du réseau d'alimentation 2 qui réalisent une mesure de tension en réponse à chaque impulsion de courant injectée sur la terre et rebouclant par le neutre du réseau d'alimentation 2.

Les processeurs d'un véhicule automobile fonctionnent à une fréquence maximale de 10 kHz. On sait déjà d'après le théorème de Shannon qu'il sera tout à fait impossible de filtrer les perturbations dues à des fréquences supérieures à 5 kHz à l'aide d'un filtre numérique. Pour pouvoir s'affranchir des perturbations hautes fréquences dans les mesures de tension, le système 1 comprend un filtre analogique 7 couplé en sortie des moyens de mesure 6 de tension.

Le filtre analogique 7 utilisé dans ce mode de réalisation est un filtre analogique du second ordre avec une fréquence de coupure à 1 kHz et un facteur d'amortissement de 0,7 afin d'obtenir une atténuation de -20 dB à 3 kHz. Il est préférable d'utiliser un filtre possédant de telles caractéristiques plutôt qu'un filtre analogique quelconque, car il permet de diminuer au maximum la durée des impulsions de courant injectées et permet ainsi une augmentation de l'amplitude des impulsions de courant injectées.

Le système 1 comprend un filtre numérique 8 couplé à la sortie du filtre analogique 7. Le filtre numérique 8 permet d'éliminer les perturbations dues aux harmoniques du réseau d'alimentation 2 entre 50 Hz et 2 kHz. Au-delà de 2 kHz, le filtre analogique atténue déjà suffisamment les perturbations.

Compte-tenu de la bande-passante du filtre analogique, pour que la tension mesurée soit bien l'image du courant des impulsions injectées, il est préférable que la durée minimale des impulsions de courant injectées corresponde au moins au temps de réponse du filtre analogique pour que le filtrage à hautes fréquences soit efficace. Pour cela, la durée des impulsions injectées doit au moins correspondre à une période du signal du réseau d'alimentation 2. Ainsi, pour un réseau d'alimentation 3 de fréquence 50 Hz, la durée minimale des impulsions de courant injectées doit être de 1 ms.

Une durée plus longue d'impulsion de courant obligerait à diminuer l'amplitude des impulsions de courant pour ne pas faire disjoncter le système. Or, il est important d'émettre des impulsions d'amplitude la plus importante possible car elles génèrent en réponse des tensions plus importantes et donc plus visibles par rapport au bruit.

Dans le cas d'un réseau d'alimentation 2 à 50 Hz, pour une impulsion de 1 ms, l'amplitude des impulsions de courant peut atteindre 20 mA au maximum sans qu'il n'y ait de risque que le système disjoncte. Une impulsion de 20 mA sur une résistance de 50 Ohms engendrera une tension de 1 V noyée dans des bruits de 50 V (sommes des bruits aux harmoniques du réseau d'alimentation). De façon numérique, il faut donc éliminer au maximum les harmoniques du réseau d'alimentation 2.

Pour ce faire le filtre numérique 8 comprend un filtre de moyenne qui présente l'avantage d'atténuer à l'infini les fréquences ciblées. Par exemple, enregistrer deux points séparés de 10 ms et en faire la moyenne permet d'éliminer totalement le 50 Hz.

Le filtre numérique est couplé aux moyens 4 de mesure de la fréquence du réseau d'alimentation 2 afin de recevoir l'information relative à la période électrique T du réseau d'alimentation 2.

En enregistrant quarante points de mesures de tension équirépartis sur les 20 ms de période électrique, il est possible d'éliminer jusqu'à la 39e harmonique du réseau, soit jusqu'à la fréquence 1950 Hz sur un réseau d'alimentation 2 fonctionnant à 50 Hz.

Cependant faire des impulsions de 1 ms espacées 500 $\mu$s chacune est impossible à faire avec une amplitude d'impulsion de 20 mA. Pour pouvoir néanmoins effectuer cette moyenne, le système réalise des mesures en se décalant à chaque nouvelle mesure d'une période électrique T du signal du réseau d'alimentation 2 en plus du décalage de mesure $d$ égal à d=T/N avec N le nombre de mesures à réaliser dans une période électrique T de signal.

Ainsi, dans le cas d'un réseau d'alimentation à 50 Hz et d'une moyenne réalisée à partir de 40 mesures, la première mesure serait réalisée à $t$ = 0, et la seconde à $t$ = 20,5ms, l'intervalle correspondant à l'addition d'une période électrique T=1/50=20ms avec un décalage de mesure d=20/40=0,5ms. Cette seconde mesure serait identique à une mesure effectuée seulement 500 $\mu$s après la première puisque le signal de bruit est périodique avec une période T=20ms.

En faisant ainsi quarante acquisitions de mesure de tension en fin d'impulsion espacées de 20,5 ms et en faisant la moyenne des tensions mesurées sur ces quarante mesures, le filtre numérique 8 élimine les perturbations aux harmoniques du réseau et permet de retrouver la composante continue due aux impulsions de courant injectées dans le réseau d'alimentation 2.

La tension moyenne ainsi filtrée numériquement est délivrée à des moyens de détermination 9 de la résistance entre la terre et le neutre du réseau d'alimentation 2. La valeur de la résistance de la terre est déterminée en divisant ladite tension moyenne par l'amplitude des impulsions de courant injectées dans le réseau d'alimentation 2.

Le système 1 comprend des moyens de commande de sécurité 10 couplés en entrée aux moyens de détermination 9 et en sortie à la batterie 3 du véhicule automobile. Si la valeur de la résistance de terre déterminée est inférieure à une valeur seuil de 500 Ohms, le couplage est réalisé avec la batterie 3 du véhicule automobile, et la charge peut démarrer. Sinon, la batterie 3 n'est pas couplée électriquement au réseau d'alimentation 2 est la charge n'a pas lieu.

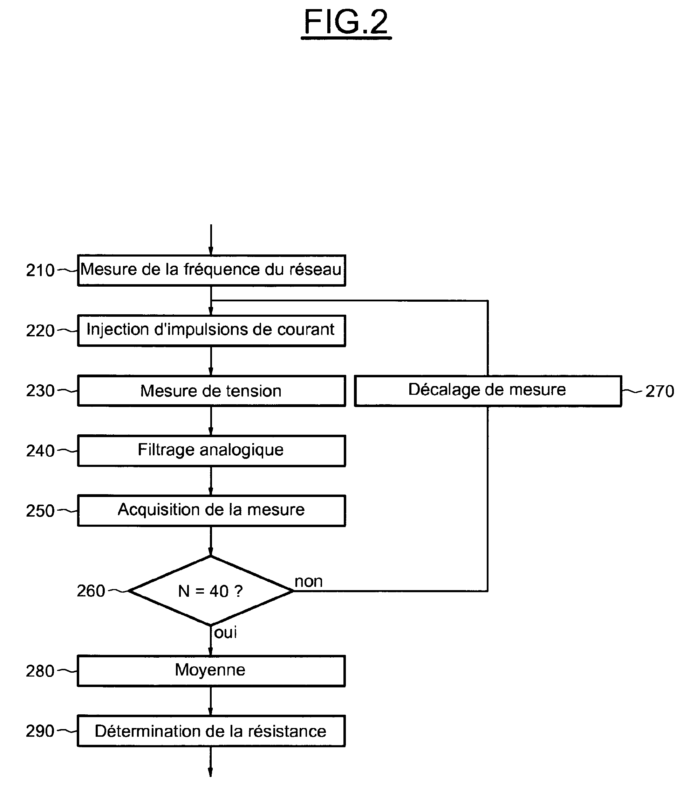

La figure 2 présente un organigramme d'un procédé d'estimation de la résistance entre la terre et le neutre d'un réseau d'alimentation utilisé pour charger une batterie d'un véhicule automobile selon un mode de mise en oeuvre.

Dans une première étape 210, on mesure la fréquence du réseau d'alimentation 2 couplé au véhicule automobile pour recharger la batterie 3 du véhicule automobile.

Dans une étape suivante 220, on injecte des impulsions de courant dans le réseau d'alimentation 2. La durée des impulsions dépend du filtre analogique 7 choisi qui dépend lui-même de la période du réseau d'alimentation 2.

Puis, dans une étape 230, on réalise des mesures de tension entre la terre et le neutre du réseau d'alimentation 2 à l'issue de chacune des impulsions de courant injectées.

Dans une étape suivante 240, on filtre analogiquement à hautes fréquences chaque tension mesurée.

On acquière la mesure ensuite, dans une étape 250, puis on teste le nombre de mesures effectuées dans une étape 260. Si on n'a pas encore effectuées 40 mesures de tension, on recommence une mesure à partir d'une nouvelle injection d'impulsion de courant à l'étape 220 sur une période électrique T suivante, en ayant décalé dans une étape 270 le moment de la mesure d'un temps de décalage d=T/N, soit dans le cas d'un réseau d'alimentation 2 à 50 Hz un temps d=0,5 ms.

Une fois la 40e mesure effectuée, on filtre numériquement à basses fréquences dans une étape suivante 280 en réalisant la moyenne des quarante tensions mesurées, et on détermine finalement, dans une étape 290, la résistance entre la terre et le neutre en divisant la tension moyenne par l'amplitude des impulsions de courant.

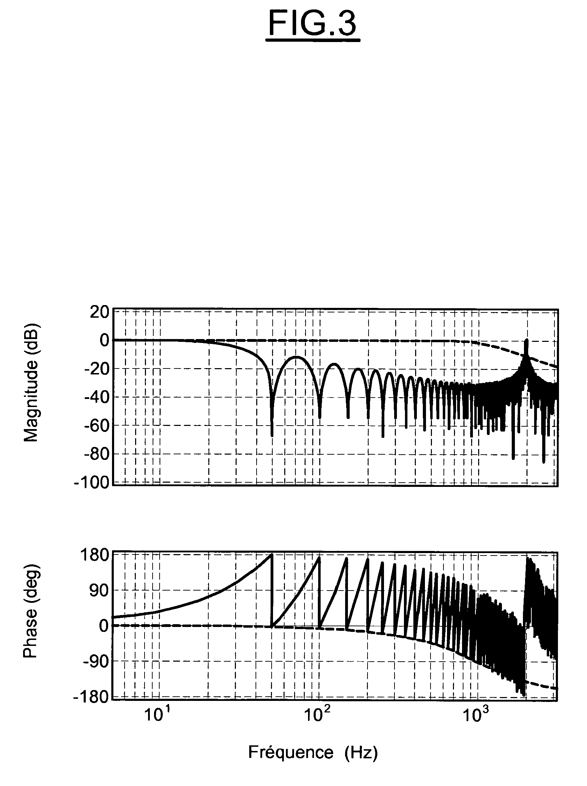

La figure 3 présente sur deux diagrammes de Bode l'amplitude et la phase des actions du filtre analogique en tirets et du filtre numérique en trait plein pour une fréquence du réseau d'alimentation 2 de 50 Hz.

Le système sécurisé 1 est adapté aux contraintes de l'automobile et permet de vérifier la qualité de la terre d'un réseau domestique avant de débuter la charge de la batterie du véhicule automobile à bord duquel le système sécurisé est embarqué.

**Revendications**

1. Système (1) sécurisé de charge de la batterie (3) d'un véhicule automobile à partir d'un réseau d'alimentation (2), le système (1) étant embarqué sur le véhicule automobile et comprenant des moyens de mesure (4) de la fréquence du réseau d'alimentation (2), des moyens d'injection (5) d'impulsions de courant dans le réseau d'alimentation (2), des moyens de mesure (6) de la tension entre la terre et le neutre du réseau d'alimentation (2), un filtre analogique (7) pour filtrer à hautes fréquences les tensions mesurées, un filtre numérique (8) pour filtrer à basses fréquences les tensions filtrées analogiquement, et des moyens de détermination (9) de la résistance entre la terre et le neutre du réseau d'alimentation (2) à partir des tensions filtrées numériquement et de l'amplitude des impulsions de courant, **caractérisé en ce que** le filtre numérique (8) comprend un filtre de moyenne déterminant une moyenne à partir de N mesures de tension espacées d'un intervalle de temps $T + \dfrac{T}{N}$, avec T la période du réseau d'alimentation (2) déterminée par les moyens de mesure (4) de la fréquence du réseau d'alimentation (2).

**2.** Système (1) selon la revendication 1, dans lequel le filtre analogique (7) est un filtre analogique du second ordre avec une fréquence de coupure comprise entre 800 Hz et 1,2 kHz, et préférentiellement 1 kHz, et un facteur d'amortissement compris entre 0,6 et 0,8, et préférentiellement de 0,7.

**3.** Système (1) selon la revendication 2, dans lequel les impulsions de courant ont une durée au moins supérieure à 0,8 ms, et préférentiellement de 1 ms et une amplitude maximale comprise entre 18 mA et 22 mA, et préférentiellement de 20 mA.

**4.** Système (1) selon l'une quelconque des revendications 1 à 3, comprenant des moyens de commande (10) de sécurité aptes à activer la charge de la batterie (3) à partir du réseau d'alimentation (2) seulement si la résistance de terre mesurée est inférieure à un seuil d'activation.

**5.** Système (1) selon la revendication 4, dans lequel le seuil d'activation correspond à une valeur de résistance comprise entre 20 et 600 Ohms, et correspond de préférence à 200 Ohms.

**6.** Procédé de charge sécurisée de la batterie (3) d'un véhicule automobile à partir d'un réseau d'alimentation (2) estimant la résistance entre la terre et le neutre du réseau d'alimentation (2), dans lequel on mesure la fréquence du réseau d'alimentation (2), on injecte des impulsions de courant dans le réseau d'alimentation (2), on réalise des mesures de tension entre la terre et le neutre du réseau d'alimentation (2) en réponse à chaque impulsion, on filtre analogiquement à hautes fréquences les tensions mesurées, on filtre numériquement à basses fréquences les tensions filtrées analogiquement, et on détermine la résistance entre la terre et le neutre à partir des tensions filtrées numériquement et de l'amplitude des impulsions de courant, **caractérisé en ce que** le filtrage numérique comprend la détermination d'une moyenne à partir de N mesures de tension espacées d'un intervalle de temps $T + \dfrac{T}{N}$, avec T la période du réseau d'alimentation (2) déterminée à partir de la mesure de la fréquence du réseau d'alimentation (2).

**7.** Procédé selon la revendication 6, dans lequel le filtrage analogique comprend un filtrage au second ordre avec une fréquence de coupure comprise entre 800 Hz et 1,2 kHz, et préférentiellement de 1 kHz, et un facteur d'amortissement compris entre 0,6 et 0,8, et préférentiellement de 0,7.

**8.** Procédé selon la revendication 7, dans lequel les impulsions de courant ont une durée au moins supérieure à 0,8 ms, et préférentiellement de 1 ms et une amplitude maximale comprise entre 18 mA et 22 mA, et préférentiellement de 20 mA.

**9.** Procédé selon l'une quelconque des revendications 6 à 8, dans lequel la durée des impulsions de courant injectées dans le réseau d'alimentation (2) correspond au moins à la période du réseau d'alimentation (2).

**10.** Procédé selon l'une quelconque des revendications 6 à 9, dans lequel on couple le réseau d'alimentation (2) à la batterie (3) seulement si la résistance de terre mesurée est inférieure à un seuil d'activation.

**Patentansprüche**

**1.** Sicheres System (1) zum Laden der Batterie (3) eines Kraftfahrzeugs aus einem Versorgungsnetz (2), wobei sich das System (1) an Bord des Kraftfahrzeugs befindet und Mittel zur Messung (4) der Frequenz des Versorgungsnetzes (2), Mittel zum Einspeisen (5) von Stromimpulsen in das Versorgungsnetz (2), Mittel zur Messung (6) der Spannung zwischen Erde und dem Neutralleiter des Versorgungsnetzes (2), ein Analogfilter (7) zum Filtern der gemessenen Spannungen bei hohen Frequenzen, ein Digitalfilter (8) zum Filtern der analog gefilterten Spannungen bei niedrigen Frequenzen und Mittel zur Bestimmung (9) des Widerstands zwischen Erde und dem Neutralleiter des Versorgungsnetzes (2) ausgehend von den digital gefilterten Spannungen und der Amplitude der Stromimpulse aufweist, **dadurch gekennzeichnet, dass** das Digitalfilter (8) ein Mittelwertfilter aufweist, welches einen Mittelwert ausgehend von N Spannungsmessungen bestimmt, die um ein Zeitintervall $T + T/N$ beabstandet sind, wobei $T$ die Periode des Versorgungsnetzes (2) ist, die von den Mitteln zur Messung (4) der Frequenz des Versorgungsnetzes (2) bestimmt wurde.

**2.** System (1) nach Anspruch 1, wobei das Analogfilter (7) ein Analogfilter zweiter Ordnung mit einer Grenzfrequenz zwischen 800 Hz und 1,2 kHz und vorzugsweise von 1 kHz und mit einem Dämpfungsfaktor zwischen 0,6 und 0,8 und vorzugsweise von 0,7 ist.

**3.** System (1) nach Anspruch 2, wobei die Stromimpulse eine Dauer, die wenigstens größer als 0,8 ms ist und vorzugsweise 1 ms beträgt, und eine maximale Amplitude zwischen 18 mA und 22 mA und vorzugsweise von 20 mA aufweisen.

**4.** System (1) nach einem der Ansprüche 1 bis 3, welches Sicherheits-Steuerungsmittel (10) aufweist, die geeignet sind, das Laden der Batterie (3) aus dem Versorgungsnetz (2) nur dann zu aktivieren, wenn der gemessene Erdungswiderstand kleiner als ein Aktivierungsschwellenwert ist.

**5.** System (1) nach Anspruch 4, wobei der Aktivierungsschwellenwert einem Widerstandswert zwischen 20 und 600 Ohm entspricht und vorzugsweise 200 Ohm entspricht.

**6.** Verfahren zum sicheren Laden der Batterie (3) eines Kraftfahrzeugs aus einem Versorgungsnetz (2), welches den Widerstand zwischen Erde und dem Neutralleiter des Versorgungsnetzes (2) schätzt, wobei die Frequenz des Versorgungsnetzes (2) gemessen wird, Stromimpulse in das Versorgungsnetz (2) eingespeist werden, Messungen der Spannung zwischen Erde und dem Neutralleiter des Versorgungsnetzes (2) in Reaktion auf jeden Impuls durchgeführt werden, die gemessenen Spannungen bei hohen Frequenzen analog gefiltert werden, die analog gefilterten Spannungen bei niedrigen Frequenzen digital gefiltert werden und der Widerstand zwischen Erde und dem Neutralleiter ausgehend von den digital gefilterten Spannungen und der Amplitude der Stromimpulse bestimmt wird, **dadurch gekennzeichnet, dass** die digitale Filterung die Bestimmung eines Mittelwertes ausgehend von N Spannungsmessungen beinhaltet, die um ein Zeitintervall *T + T/N* beabstandet sind, wobei *T* die Periode des Versorgungsnetzes (2) ist, die aus der Messung der Frequenz des Versorgungsnetzes (2) bestimmt wurde.

**7.** Verfahren nach Anspruch 6, wobei die analoge Filterung eine Filterung zweiter Ordnung mit einer Grenzfrequenz zwischen 800 Hz und 1,2 kHz und vorzugsweise von 1 kHz und mit einem Dämpfungsfaktor zwischen 0,6 und 0,8 und vorzugsweise von 0,7 beinhaltet.

**8.** Verfahren nach Anspruch 7, wobei die Stromimpulse eine Dauer, die wenigstens größer als 0,8 ms ist und vorzugsweise 1 ms beträgt, und eine maximale Amplitude zwischen 18 mA und 22 mA und vorzugsweise von 20 mA aufweisen.

**9.** Verfahren nach einem der Ansprüche 6 bis 8, wobei die Dauer der Stromimpulse, die in das Versorgungsnetz (2) eingespeist werden, wenigstens der Periode des Versorgungsnetzes (2) entspricht.

**10.** Verfahren nach einem der Ansprüche 6 bis 9, wobei das Versorgungsnetz (2) mit der Batterie (3) nur dann gekoppelt wird, wenn der gemessene Erdungswiderstand kleiner als ein Aktivierungsschwellenwert ist.

**Claims**

**1.** Secure system (1) for charging the battery (3) of a motor vehicle from a power supply network (2), the system (1) being on board the motor vehicle and comprising means (4) for measuring the frequency of the power supply network (2), means (5) for injecting current pulses into the power supply network (2), means (6) for measuring the voltage between the earth and the neutral of the power supply network (2), an analog filter (7) for filtering the measured voltages at high frequencies, a digital filter (8) for filtering the analog-filtered voltages at low frequencies, and means (9) for determining the resistance between the earth and the neutral of the power supply network (2) on the basis of the digitally filtered voltages and the amplitude of the current pulses, **characterized in that** the digital filter (8) comprises a mean value filter determining a mean value on the basis of N voltage measurements spaced apart by a time interval T + T/N, with T the period of the power supply network (2) determined by the means (4) for measuring the frequency of the power supply network (2).

**2.** System (1) according to Claim 1, wherein the analog filter is a second-order analog filter with a cut-off frequency lying between 800Hz and 1.2Hz, and preferably of 1kHz, and a damping factor lying between 0.6 and 0.8, and preferably of 0.7.

**3.** System (1) according to Claim 2, wherein the current pulses have a duration at least above 0.8 ms, and preferably of 1ms, and a maximum amplitude lying between 18mA and 22mA, and preferably of 20mA.

**4.** System (1) according to any one of Claims 1 to 3, comprising secure command means (10) capable of activating the charging of the battery (3) from the power supply network (2) only if the measured earth resistance is below an activation threshold.

**5.** System (1) according to Claim 4, wherein the activation threshold corresponds to a resistance value lying between 20 and 600 ohms, and preferably of 200 ohms.

**6.** Secure method for charging the battery (3) of a motor vehicle from a power supply network (2) estimating the resistance between the earth and the neutral of the power supply network (2), wherein the frequency of the power supply network (2) is measured, current pulses are injected into the power supply network (2), measurements of the voltage between the earth and the neutral of the power supply network (2) are performed in response to each pulse, the measured voltages are analog-filtered at high frequencies, the analog-filtered voltages are filtered digitally at low frequencies, and the resistance between the earth and the neutral is determined on the basis of the digitally filtered voltages and the amplitude of the current pulses, **characterized in that** the digital filtering comprises the determining of a mean value on the basis of N voltage measurements spaced apart by a time interval T + T/N, with T the period of the power supply network (2) determined on the basis of the measurement of the frequency of the power supply network (2).

7. Method according to Claim 6, wherein the analog filtering comprises a second-order filtering with a cut-off frequency lying between 800Hz and 1.2Hz, and preferably of 1kHz, and a damping factor lying between 0.6 and 0.8, and preferably of 0.7.

8. Method according to Claim 7, wherein the current pulses have a duration at least above 0.8 ms, and preferably of 1ms, and a maximum amplitude lying between 18mA and 22mA, and preferably of 20mA.

9. Method according to any one of Claims 6 to 8, wherein the duration of the current pulses injected into the power supply network (2) corresponds at least to the period of the power supply network (2).

10. Method according to any one of Claims 6 to 9, wherein the power supply network (2) is coupled to the battery (3) only if the measured earth resistance is below an activation threshold.

## FIG.1

EP 2 812 711 B1

# FIG.2

210 — Mesure de la fréquence du réseau

220 — Injection d'impulsions de courant

230 — Mesure de tension                    Décalage de mesure — 270

240 — Filtrage analogique

250 — Acquisition de la mesure

260 — N = 40 ?    non

oui

280 — Moyenne

290 — Détermination de la résistance

# FIG.3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CN 201508392
- EP 1482317 A

- EP 642027 A